# EUROPEAN PATENT SPECIFICATION

(11) **EP 4 248 223 B1**
(45) Date of publication and mention of the grant of the patent: **25.03.2026**
(21) Application number: 21806724.7
(22) Date of filing: 08.11.2021
(51) Int. Cl.: B60L 3/04, G01R 19/155, G01R 31/00, B60L 3/00

(54) **A MONITORING DEVICE FOR AN AT LEAST PARTIALLY ELECTRICALLY OPERATED MOTOR VEHICLE**
ÜBERWACHUNGSVORRICHTUNG FÜR EIN ZUMINDEST TEILWEISE ELEKTRISCH BETRIEBENES KRAFTFAHRZEUG
DISPOSITIF DE SURVEILLANCE POUR UN VÉHICULE À MOTEUR AU MOINS PARTIELLEMENT ÉLECTRIQUE

(30) Priority: 23.11.2020 GB 202018343
(43) Date of publication of application: 27.09.2023
(73) Proprietor: Daimler Truck AG, 70771 Leinfelden-Echterdingen (DE)
(72) Inventor: HUNLEY, Bret, St. Helens, OR 97051 (US); OLIVARES, Hector, Portland, OR 97229 (US); SCHEIBA, Kevin, Beaverton, OR 97006 (US)
(74) Representative: impuls legal PartG mbB
(86) International application number: PCT/EP2021/080981
(87) International publication number: WO 2022/106245

(56) References cited:
- KR-A- 20140 001 814
- US-A1- 2010 187 904
- US-A1- 2014 375 116
- US-A1- 2018 113 157
- US-B1- 10 027 070

## Description

### FIELD OF THE INVENTION

The present disclosure relates to the field of automobiles. More particularly, but not specifically, the present disclosure relates to a monitoring device for an at least partially electrically operated motor vehicle.

### BACKGROUND INFORMATION

With the emergence of electric vehicles, there is a growing need during maintenance and/or decommissioning of an electric vehicle to test for the presence of high voltage provided by the electric vehicle's high voltage system. Depending on the type of testing required during maintenance, a user may need to test and/or measure the amount of high voltage present in the high voltage system of the electric vehicle. Further, during decommissioning of an electric vehicle, a user may need to test to ensure there is no high voltage present in the high voltage system prior to proceeding with the decommissioning process. Due to the amount of high voltage provided by high voltage systems of electric vehicles, particularly electric commercial vehicles, testing and monitoring of high voltage systems can be dangerous for a user to perform.

CN104678311A provides a detection device for a power voltage state of an electric automobile. The detection device is arranged in a high-voltage control box of the electric automobile and comprises a resistance voltage dividing circuit, an operation amplification circuit, a voltage comparison circuit and an output display circuit, which are in series connection sequentially, wherein the voltage comparison circuit is further electrically connected with a reference voltage circuit. According to the detection device provided by the embodiments of the invention, an actual voltage value of power voltage of the electric automobile is not acquired, but an acquired voltage value is compared with reference voltage, so that the overall power-on state of the electric automobile may be detected, and whether an overall high-voltage system has remaining power or not after a power rechargeable battery is powered off may be detected; the detection device does not adopt an Analog-to-Digital sampling circuit design scheme and does not adopt a microprocessor so that the detection device plays a great role in reducing the influence on power wire harnesses caused by common mode interference, and potential display error risk resulting from interference on a Controller Area Network is avoided.

US 2018/113 157 A1 discloses a high voltage test and service module configured to electrically couple to a high voltage circuit of a vehicle. The module includes a module housing, a fuse disposed in the module housing, a positive high voltage test point disposed in the module housing, and a negative high voltage test point disposed in the module housing. A first high voltage interlock (HVIL) connector is disposed in the module housing and configured to electrically couple to a high voltage interlock. A second HVIL connector is removably disconnected from the first HVIL connector to break the high voltage interlock. The positive and negative high voltage test points enable testing and monitoring of the high voltage circuit to determine if a voltage or current resides on the high voltage circuit before servicing thereof.

There exists a need in the art for a monitoring device provided on an electric vehicle by which more efficient monitoring and/or testing of high voltage systems of an electric vehicle may be performed. There also exists a need in the art to provide a monitoring device with a greater standard of safety in order to better protect a user from the dangers of testing a high voltage system of an electric vehicle.

It is an object of the invention to provide a monitoring device by which a more efficient and safe monitoring of at least one high voltage connection of an at least partially electrically operated motor vehicle may be realized.

This object is solved by a monitoring device according to the independent claim. Advantageous embodiments are indicated in the dependent claims.

### SUMMARY OF THE INVENTION

The invention relates to a monitoring device for an at least partially electrically operated motor vehicle. The monitoring device comprises a housing configured to be arranged on the motor vehicle and to accept at least one high voltage input connection. The monitoring device further comprises an access door configured to provide access to a user interface.

The monitoring device comprises at least one electric circuit for monitoring the presence of high voltage provided by the at least one high voltage input connection. The monitoring device further comprises at least one high voltage interlock protection circuit. The at least one electric circuit for monitoring the presence of high voltage and the at least one high voltage interlock protection circuit are provided within the housing.

The monitoring device comprises a microcontroller. The microcontroller controls the at least one electric circuit for monitoring the presence of high voltage. The microcontroller further controls the at least one high voltage interlock protection circuit. The microcontroller further controls indication provided through the user interface based on the presence of high voltage within the electric circuit for monitoring the presence of high voltage.

The access door comprises an interlock switch configured to break continuity in the at least one high voltage interlock protection circuit upon opening of the access door.

In another embodiment, the at least one electric circuit for monitoring the presence of high voltage comprises a primary circuit controlled by the microcontroller for monitoring the presence of high voltage. The at least one electric circuit for monitoring the presence of high voltage further comprises a secondary circuit controlled by the microcontroller for monitoring for faults within the at least one electric circuit for monitoring the presence of high voltage.

In yet another embodiment, the user interface comprises at least one indication light controlled by the microcontroller.

In an embodiment, the user interface comprises at least one coupling device. The coupling device is configured to connect to an external monitoring or probing device.

In another embodiment, the user interface comprises a mode switch that is configured to initiate a testing sequence controlled by the microcontroller.

In another embodiment, the microcontroller is configured to activate the secondary circuit of the at least one electric circuit for monitoring the presence of high voltage when the primary circuit of the at least one electric circuit for monitoring the presence of high voltage does not detect the presence of high voltage.

In yet another embodiment, the microcontroller is configured to receive a safety interlock signal that indicates the operating state of the vehicle, wherein the microcontroller controls the operating state of the monitoring device based on the safety interlock signal.

In an embodiment, the microcontroller is configured to control the at least one electric circuit for monitoring the presence of high voltage and the high voltage interlock protection circuit through at least one transistor.

In another embodiment, the user interface may comprise a door override switch configured to restore continuity in the high voltage interlock protection circuit after the access door is opened. The microcontroller is configured to close a transistor upon engagement of the door override switch.

Another embodiment of the invention relates to an at least partially electrically operated motor vehicle with a monitoring device according to the preceding embodiments. In particular, the motor vehicle is a fully electrically operated motor vehicle.

Advantageous forms of configurations of the monitoring device are regarded to be advantageous forms of configuration of the at least partially electrically operated motor vehicle.

Further advantages, features, and details of the invention derive from the following description of preferred embodiments as well as from the drawings. The features and feature combinations previously mentioned in the description as well as the features and feature combinations mentioned in the following description of the figures and/or shown in the figures alone may be employed not only in the respectively indicated combination but also in any other combination or taken alone without leaving the scope of the invention.

### BRIEF DESCRIPTION OF THE DRAWINGS

The novel features and characteristics of the disclosure are set forth in the appended claims. The accompanying drawings, which are incorporated in and constitute a part of this disclosure, illustrate exemplary embodiments and together with the description, serve to explain the disclosed principles. In the figures, same reference signs are used throughout the figures to refer to identical features and components. Some embodiments of a system and/or methods in accordance with embodiments of the present subject matter are now described below, by way of example only, and with reference to the accompanying figures.

The drawings show in:
Fig. 1 a perspective view of an embodiment of a monitoring device;
Fig. 2 an isometric view of an embodiment of the monitoring device;
Fig. 3 a side view of an embodiment of the monitoring device;
Fig. 4 a side view of an alternative embodiment of the monitoring device;
Fig. 5 a schematic view of a user interface of the monitoring device;
Fig. 6 a schematic view of an electric circuit of the monitoring device, in particular a circuit for powering the monitoring device;
Fig. 7 another schematic view of an electric circuit of the monitoring device, in particular for controlling at least one aspect of the user interface;
Fig. 8 another schematic view of an electric circuit of the monitoring device, in particular a high voltage interlock protection circuit;
Fig. 9 another schematic view of an electric circuit of the monitoring device, in particular an alternative embodiment of the high voltage interlock protection circuit;
Fig. 10 another schematic view of an electric circuit of the monitoring device, in particular for detecting the presence of high voltage provided by a high voltage connection;
Fig. 11 another schematic view of an electric circuit of the monitoring device, in particular for detecting the presence of high voltage provided by a high voltage connection;
Fig. 12 another schematic view of an electric circuit of the monitoring device, in particular for detecting the presence of high voltage provided by a high voltage connection;
Fig. 13 another schematic view of an electric circuit of the monitoring device, in particular for detecting the presence of high voltage provided by a high voltage connection;
Fig. 14 another schematic view of an electric circuit of the monitoring device, in particular for detecting the presence of high voltage provided a high voltage connection; and in
Fig. 15 another schematic view of an electric circuit of the monitoring device, in particular for detecting the presence of high voltage provided a high voltage connection.
Fig. 16 another schematic view of an electric circuit of the monitoring device, in particular for detecting the presence of high voltage provided a high voltage connection.
Fig. 17 another schematic view of an electric circuit of the monitoring device, in particular for detecting the presence of high voltage provided a high voltage connection.

In the figures same elements or elements having the same function are indicated by the same reference signs.

### DETAILED DESCRIPTION

In the present document, the word "exemplary" is used herein to mean "serving as an example, instance, or illustration." Any embodiment or implementation of the present subject matter described herein as "exemplary" is not necessarily to be construed as preferred or advantageous over other embodiments.

While the disclosure is susceptible to various modifications and alternative forms, specific embodiments thereof have been shown by way of example in the drawings and will be described in detail below. It should be understood, however, that it is not intended to limit the disclosure to the particular forms disclosed, but on the contrary, the disclosure is to cover all modifications, equivalents, and alternatives falling within the scope of the disclosure.

The terms "comprises", "comprising", or any other variations thereof, are intended to cover a non-exclusive inclusion so that a setup, device or method that comprises a list of components or steps does not include only those components or steps but may include other components or steps not expressly listed or inherent to such setup or device or method. In other words, one or more elements in a system or apparatus preceded by "comprises" or "comprise" does not or do not, without more constraints, preclude the existence of other elements or additional elements in the system or method.

In the following detailed description of the embodiments of the disclosure, reference is made to the accompanying drawings that form a part hereof, and in which are shown by way of illustration specific embodiments in which the disclosure may be practiced. These embodiments are described in sufficient detail to enable those skilled in the art to practice the disclosure, and it is to be understood that other embodiments may be utilized and that changes may be made without departing from the scope of the present disclosure. The following description is, therefore, not to be taken in a limiting sense.

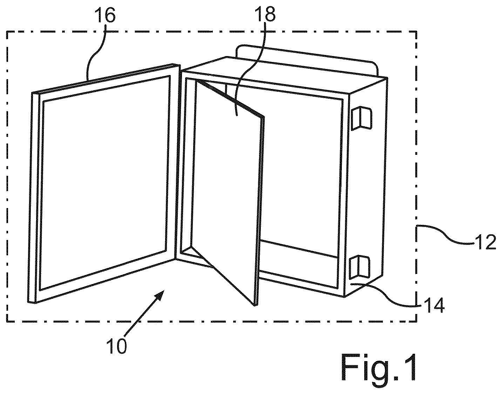

Fig. 1 shows a perspective view of a monitoring device 10 for an at least partially electrically operated motor vehicle 12. The monitoring device 10 may be used by a user to monitor at least one high voltage connection from the at least partially electrically operated motor vehicle 12. For example, the monitoring device 10 may be used in order to determine that there is no high voltage present provided by the at least one high voltage connection while decommissioning the vehicle 12. In another example, the monitoring device 10 may be used in order to safely facilitate the monitoring of live high voltage provided by the least one high voltage connection using an external monitoring device, such as a multimeter, when the vehicle 12 is in a stationary state.

In Fig. 1, a housing 14 of the monitoring device 10 is shown. The housing 14 comprises an access door 16 and an interior wall 18. The housing 14 is configured such that it may be fixed to the motor vehicle 12 where it is accessible to a user of the monitoring device 10. In an embodiment, the exterior housing 14 may be made of metal or of a conductive material. In another embodiment, the housing 14 may provide a conductive path for at least one high voltage shield connection and an exterior ground reference.

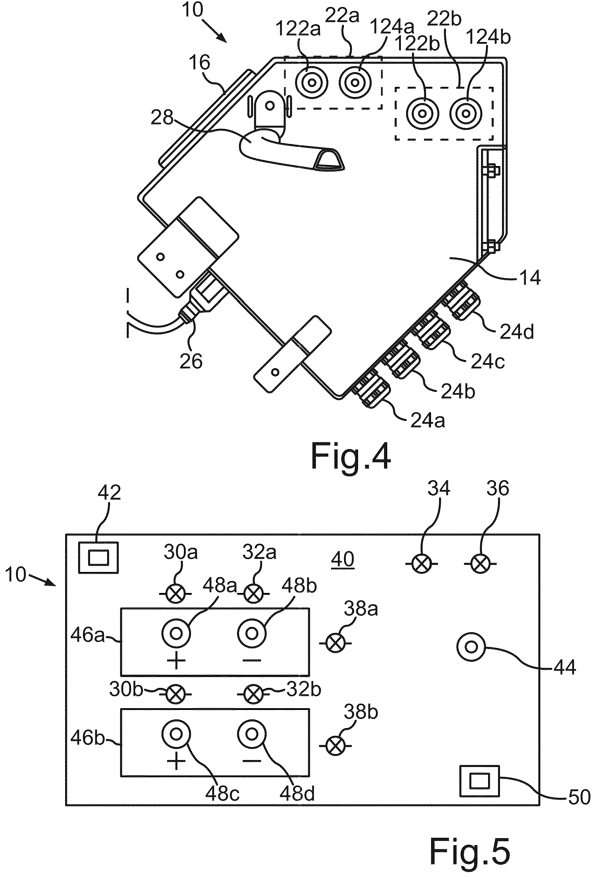

In an embodiment, the interior of the monitoring device 10 may be designed to isolate its control circuits from a user interface 40 (shown in Fig. 5). In an exemplary embodiment, the access door 16 may be opened by a user to access the user interface 40. The interior wall 18 may isolate interior cabling from the user when they are interacting with the user interface 40 while the access door 16 is open. In another embodiment, the access door 16 and the interior wall 18 may be of a minimal distance apart. The distance between the access door 16 and the interior wall 18 may be of at least a size that prevents power propagation, but also prevents external measuring or probing devices, or other items, from remaining connected to the user interface 40 when the access door 16 of the monitoring device 10 is closed.

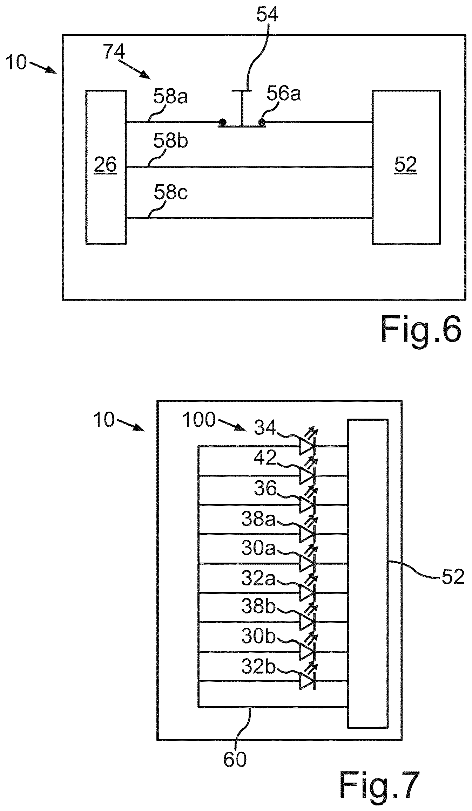

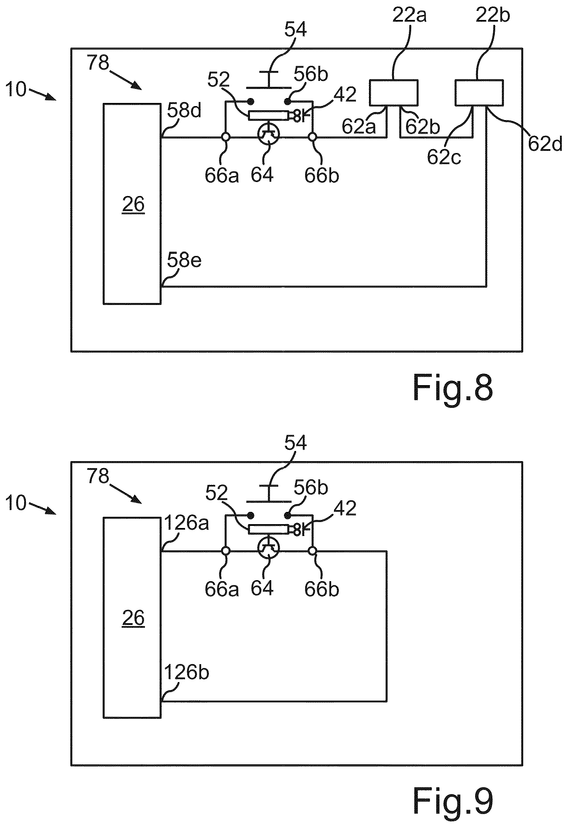

In an embodiment, the hinge of the access door 16 may comprise a door switch 54 (schematically shown in Figs. 6, 8 and 9) with two sets of contacts: one normally closed contact 56a (shown in Fig. 6) and one normally open contact 56b (shown in Figs. 8 and 9). In an embodiment, the door switch 54 is considered actuated when the access door 16 is in a closed position. In other words, when the access door 16 is closed, the normally closed contact 56a may be open and the normally open contact 56b may be closed. In an embodiment, when the access door 16 is opened, the configuration of the door switch 54 may prevent live voltage from being present in the monitoring device 10 by default unless the user overrides the door switch 54. Therefore, in an embodiment, the door switch 54 may act as a safety interlock device to prevent the user from interacting with live high voltage through the monitoring device 10 without first initiating this action through the user interface 40.

The mounting of the monitoring device 10, in particular of the housing 14, may be executed with exterior flanges, secondary brackets, through bolts and/or similar mounting means. In an exemplary embodiment, the monitoring device 10 may be secured to the motor vehicle 12 with, for example, at least one mounting point. In an embodiment, the monitoring device 10 may be made of a material that is durable and able to withstand in a chassis mounted environment. For example, the monitoring device 10 may not degrade when subjected to road/driving conditions and is resistant to road debris, salts and other road treatments.

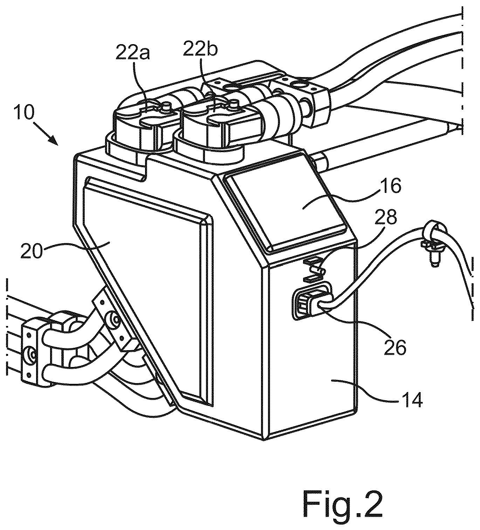

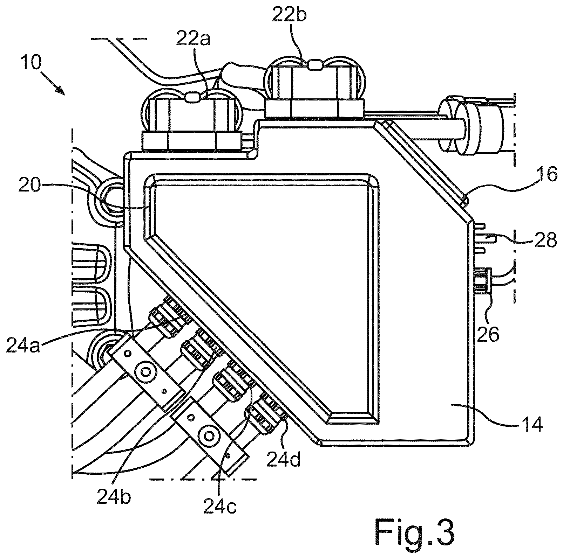

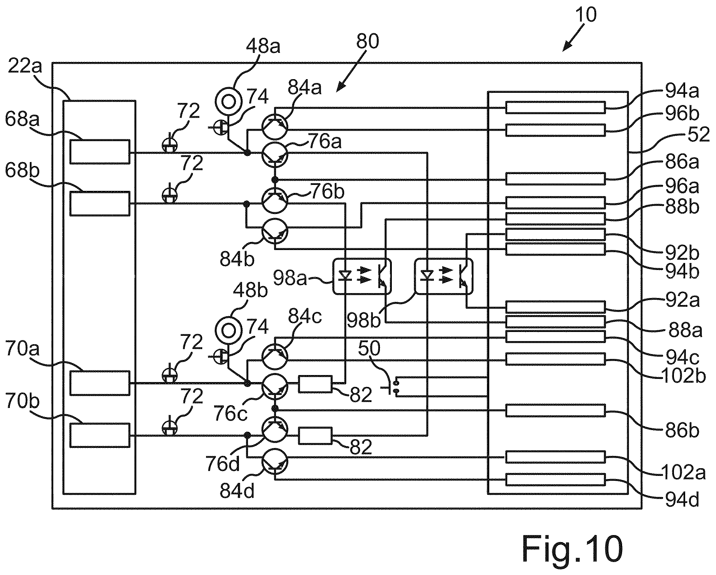

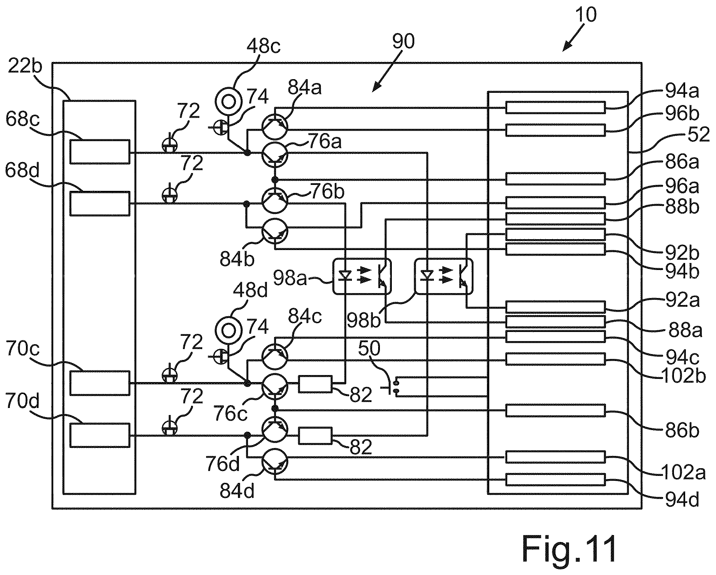

Figs. 2 and 3 show an isometric view and a side view, respectively, of an exemplary embodiment of the exterior of the monitoring device 10. The monitoring device 10, on a front side of the housing 14, comprises the access door 16 where a user may access the user interface 40. The housing 14 of the monitoring device 10 may be designed in order to allow the monitoring device 10 to accommodate several external electrical connections. It should be appreciated that the monitoring device 10 may accept at least one high voltage connection. In the exemplary embodiment depicted in Fig. 2 and 3, the monitoring device 10 accepts a first and a second high voltage input connection 22a and 22b. In an exemplary embodiment, the high voltage input connections 22a and 22b each may comprise six pins, such as four power input pins and two high voltage interlock loop (HVIL) pins. For instance, Fig. 8 depicts the HVIL input pin 62a and output pin 62b of the high voltage input connection 22a, and HVIL input pin 62c and output pin 62d of the high voltage input connection 22b. Further, Fig. 10 depicts high voltage power positive input pins 68a, 68b and high voltage power negative input pins 70a, 70b of the high voltage input connection 22a. Further, Fig. 11 depicts high voltage power positive input pins 68c, 68d and high voltage power negative input pins 70c, 70d of the high voltage input connection 22b.

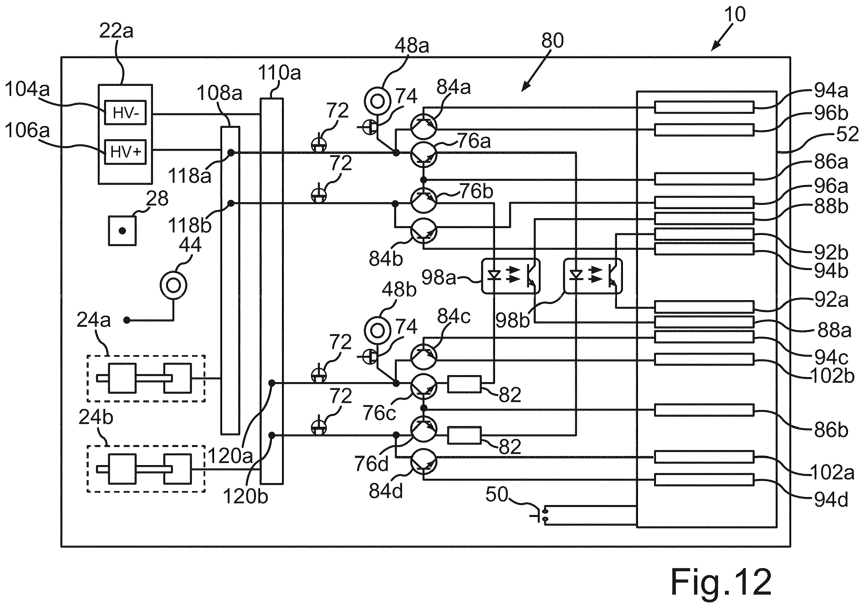

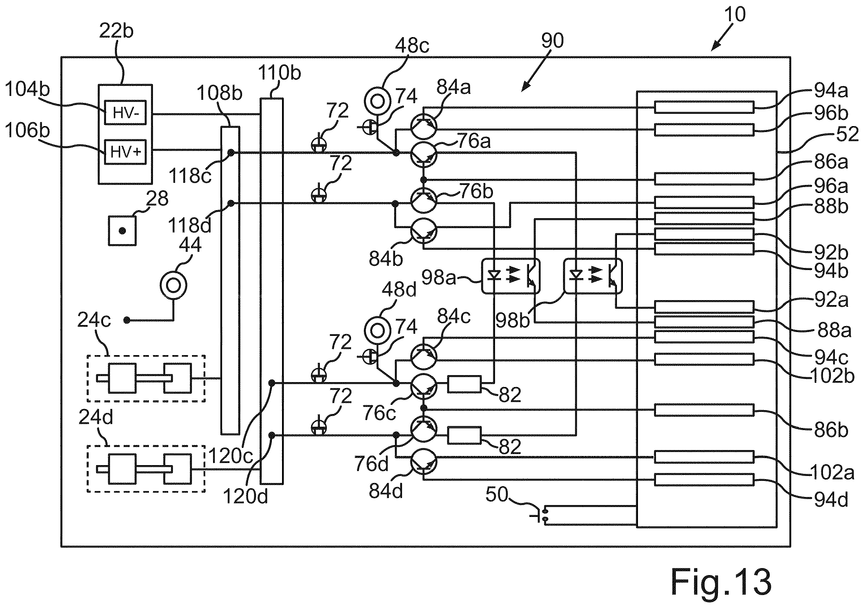

In an alternative embodiment, the monitoring device 10 may be designed to accommodate at least one high voltage input connection where connection and measurements of the at least one high voltage input connection are made directly within the monitoring device 10 through at least one bus bar. Fig. 12 depicts an alternative embodiment where a first positive bus bar 108a is connected to a positive input 106a of the first high voltage input connection 22a, and a first negative bus bar 110a is connected to a negative input 104a of the first high voltage input connection 22a. Fig. 13 further depicts a second positive bus bar 108b that is connected to a positive input 106b of the second high voltage input connection 22b, and a negative bus bar 110b that is connected to a negative input 104b of the second high voltage input connection 22b. In an embodiment, the bus bars 108a, 108b, 110a, and 110b are all arranged within the housing 14 of the monitoring device 10. It should be appreciated that in the alternative embodiment depicted in Figs. 12 and 13, the at least one high voltage input connection 22a, 22b may further comprise the HVIL input pins 62a and 62c and output pins 62b and 62d as depicted in Fig. 8.

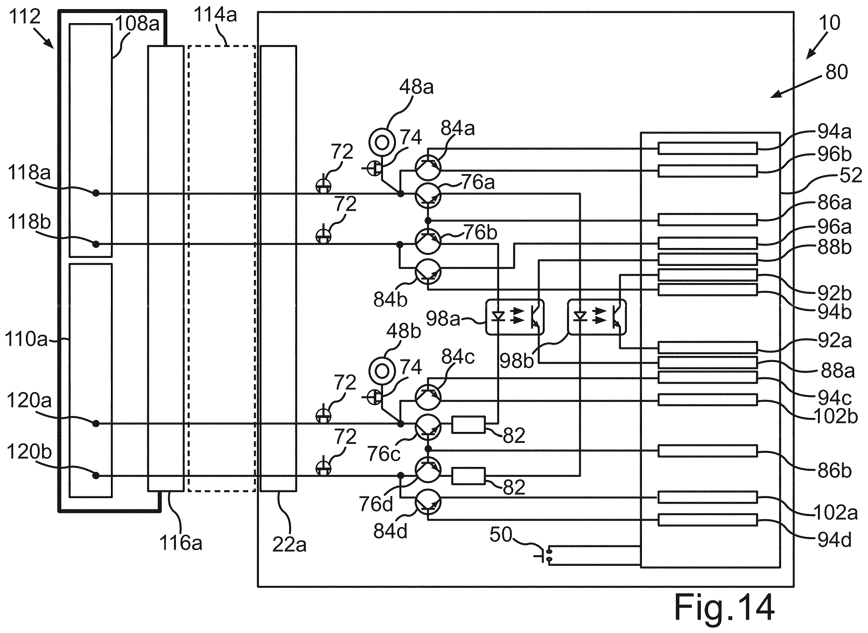

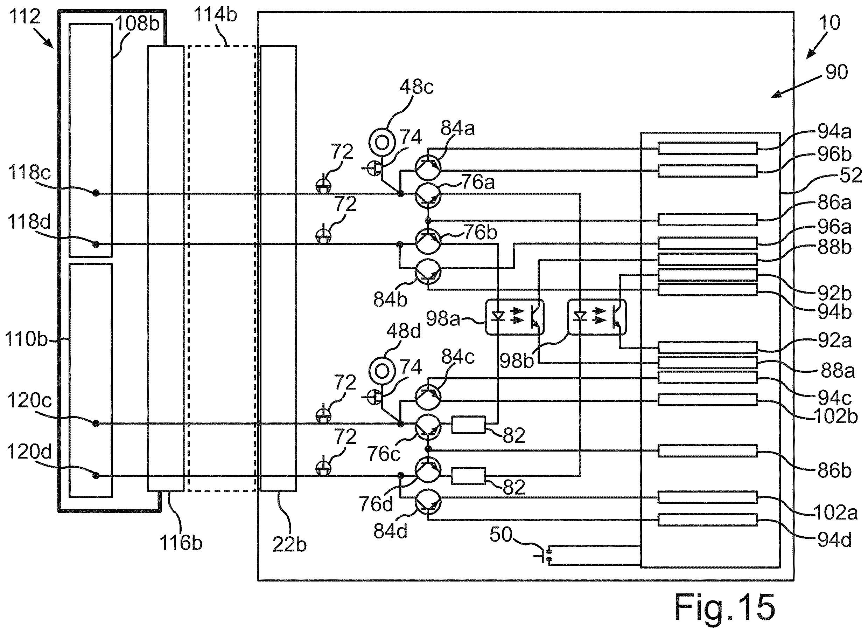

In another alternative embodiment, the monitoring device 10 may be designed to accommodate at least one high voltage input connection where connection and measurements of the at least one high voltage input connection are made through connection to a remote and/or centralized power distribution unit (PDU) of the at least partially electrically operated motor vehicle 12. Fig. 14 depicts an alternative embodiment where the at least partially electrically operated motor vehicle 12 comprises a PDU 112 that comprises a first positive bus bar 108a and a first negative bus bar 110a. The first high voltage input connection 22a may be connected to the PDU 112 through a first high voltage connection 116a. In an embodiment, the first high voltage input connection 22a and the first high voltage connection 116a may be coupled through a first high voltage cable 114a. In an embodiment, by connecting the first high voltage input connection 22a, through the first high voltage cable 114a and the first high voltage connection 116a, to the PDU 112, the monitoring device 10 may connect to and make measurements from the first positive bus bar 108a and the first negative bus bar 108b in order to detect the presence of high voltage provided from the first high voltage input connection 22a. Fig. 15 depicts an alternative embodiment where the at least partially electrically operated motor vehicle 12 comprises the PDU 112 that comprises a second positive bus bar 108b and a second negative bus bar 110b. The second high voltage input connection 22b may be connected to the PDU 112 through a second high voltage connection 116b. In an embodiment, the second high voltage input connection 22b and the second high voltage connection 116b may be coupled through a second high voltage cable 114b. In an embodiment, by connecting the high voltage input connection 22b, through the second high voltage cable 114b and the second high voltage connection 116b, to the PDU 112, the monitoring device 10 may connect to and make measurements from the second positive bus bar 108b and the second negative bus bar 110b in order to detect the presence of high voltage provided from the second high voltage input connection 22b. It should be appreciated that in the alternative embodiment depicted in Figs. 14 and 15, the at least one high voltage input connection 22a, 22b may further comprise the HVIL input pins 62a and 62c and output pins 62b and 62d as depicted in Fig. 8.

The monitoring device 10 also comprises output connections for the first and second high voltage input connections 22a and 22b, particularly a first positive high voltage output 24a, a first negative high voltage output 24b, a second positive high voltage output 24c, and a second negative high voltage output 24d. In an exemplary embodiment, the monitoring device 10 further comprises an access door 20. The access door 20 may be opened during assembly, for example, to access the securing location for high voltage outputs 24a, 24b, 24c, and 24d. In an exemplary embodiment, the high voltage outputs 24a, 24b, 24c, and 24d may be terminated through a ring terminal, and the access door 20 may be opened to access the bolt down location for the ring terminal. In an exemplary embodiment, the access door 20 may be designed to comprise its own safety interlock system/device, such as a door switch and/or a high voltage interlock protection circuit, such as a high voltage interlock loop circuit or a KL30C circuit, in order to protect the user from high voltage when opening the access door 20.

The housing 14 of the monitoring device 10 may additionally be designed in order to allow the monitoring device 10 to accommodate at least one low voltage connection 26. The low voltage connection 26 may provide power to the monitoring device 10 to enable its overall operation. Low voltage power provided by the connection 26 may particularly enable different features of the monitoring device 10 such as, but not limited to, the user interface 40, internal controls (e.g. microcontroller 52 depicted in Figs. 6-17) and safety interlock systems (e.g. safety interlock signal 58c depicted in Fig. 6, or the at least one high voltage interlock protection circuit 78 depicted in Figs. 8 and 9). In an embodiment, the low voltage connection 26 may be provided by the at least electrically operated motor vehicle 12. For example, the low voltage connection 26 may be routed from the chassis of the motor vehicle 12 through a conductive path provided by the housing 14 that is mounted, for example, to the chassis of the motor vehicle 12.

In an embodiment, the low voltage connection 26 may supply at least one circuit comprising a low voltage connection, which may comprise, for example, a power connection 58a (shown in Fig. 6) for the monitoring device 10, which may for example be a 12 volt or 24 volt connection, a ground connection 58b (shown in Fig. 6), a safety interlock connection 58c (shown in Fig. 6), and a high voltage interlock input 58d, 126a (shown in Figs. 8 and 9, respectively) and output 58e, 126b (shown in Figs. 8 and 9, respectively) connections. It should be appreciated that as desired levels of functionality of the monitoring device 10 change, other circuits, such as a controller area network (CAN), interlocks, or other signals, may also be added. For example, in an embodiment, a high voltage interlock loop (HVIL) circuit, as depicted in Fig. 8, and a KL30C circuit, as depicted in Fig. 9, can either or both be provided by the monitoring device 10.

The monitoring device 10 further comprises a ground stud 28 which may be electrically and physically bonded to the exterior of the monitoring device 10. The ground stud 28 may also be electrically connected to the at least one high voltage input connection 22a, 22b through the housing 14. Additionally, the monitoring device 10 provides an electrically bonded connection to accommodate an electrical connection between the ground stud 28 and a ground reference test port 44 (depicted in Figs. 5, 12 and 13) on the user interface 40.

Fig. 4 shows a side view of an alternative exemplary embodiment to the exterior of the monitoring device 10. The monitoring device 10, as depicted in Fig. 4, may accept two high voltage input connections 22a and 22b. In an embodiment, the high voltage input connections 22a and 22b may be connected to the monitoring device 10 through a conductive path provided by the housing 14 by cable and gland connections. In particular, the first high voltage input connection 22a may comprise a positive cable and gland input 122a, and a negative cable and gland input 124a. The second high voltage input connection 22b may comprise a positive cable and gland input 122b, and a negative cable and gland input 124b.

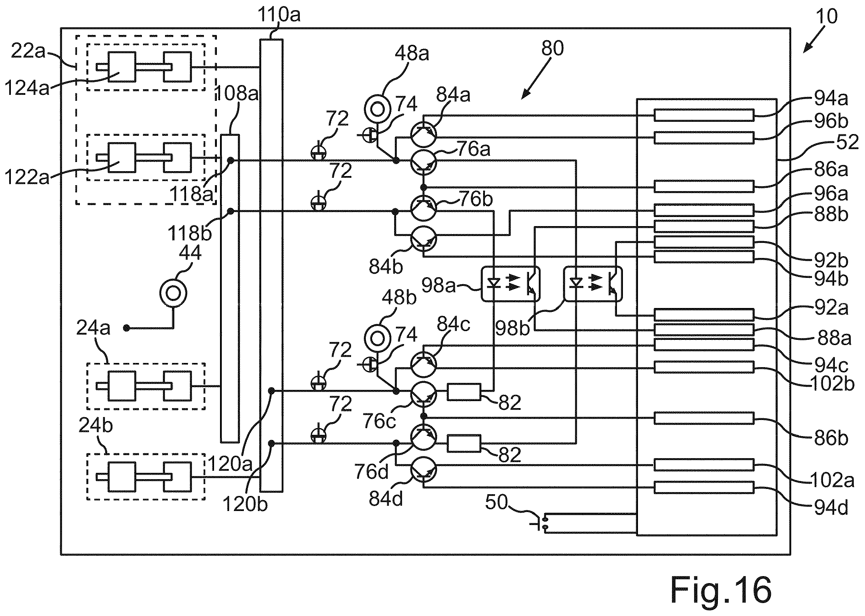

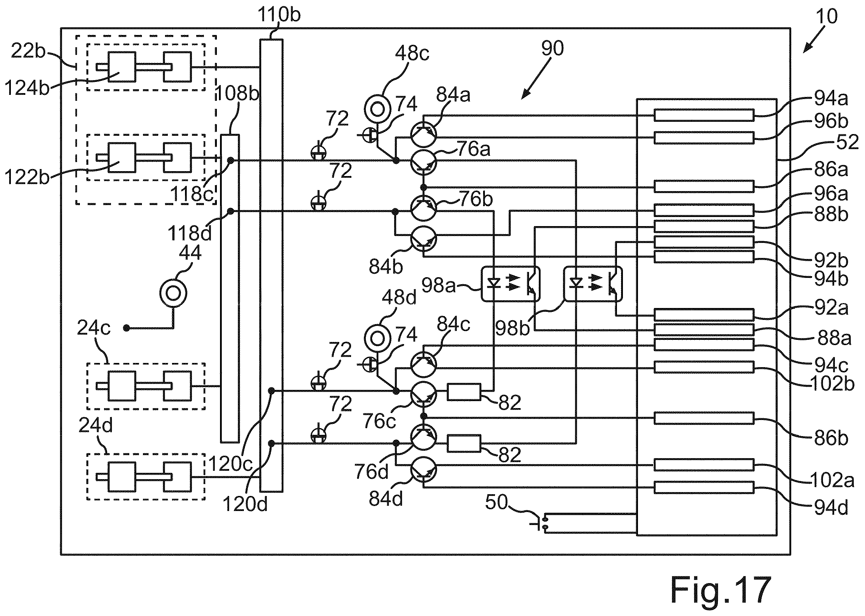

In an embodiment, the monitoring device 10 may be designed to accommodate at least one high voltage input connection where connection and measurements of the at least one high voltage input connection are made directly within the monitoring device 10 through at least one bus bar. Fig. 16 depicts an embodiment where a first positive bus bar 108a is connected to the positive cable and gland input 122a of the first high voltage input connection 22a, and a first negative bus bar 110a is connected to the negative cable and gland input 124a of the first high voltage input connection 22a. Fig. 17 further depicts a second positive bus bar 108b that is connected to the positive cable and gland input 122b of the second high voltage input connection 22b, and a second negative bus bar 110b that is connected to the negative cable and gland input 124b of the second high voltage input connection 22b. In an embodiment, the bus bars 108a, 108b, 110a, and 110b are all arranged within the housing 14 of the monitoring device 10.

Fig. 5 shows a schematic view of an interior of the monitoring device 10. In particular, Fig. 5 depicts the user interface 40 of the monitoring device 10. In an embodiment, the user interface 40 may be accessed when the access door 16 is opened by the user. The user interface 40 is designed to facilitate the safe assessment of the level of operation of at least one high voltage connection, for example high voltage input connections 22a and/or 22b, of the at least partially electrically operated motor vehicle 12 through a combination of visual indications (e.g. indication lights) and/or test ports compatible with external monitoring or probing devices (e.g. multimeters) and/or switches (e.g. push buttons).

The monitoring device 10 comprises at least one coupling device which is configured to be connected with the at least one high voltage connection of the at least partially electrically operated motor vehicle 12. In an embodiment, the monitoring device 10 may be designed to comprise the same number of coupling devices as the number of high voltage input connections. In the exemplary embodiment depicted in Figs. 2 and 3, the monitoring device 10 comprises two high voltage input connections 22a and 22b. Based on this exemplary embodiment, the user interface 40 depicted in Fig. 5 comprises two coupling devices 46a and 46b.

In an embodiment, the coupling devices 46a and 46b may be test ports that are accessible to the user through the user interface 40. The coupling devices 46a and 46b each comprise a positive port 48a, 48c and a negative port 48b, 48d. The coupling devices 46a and 46b may be used by a user to connect an external monitoring or probing device, such as a multimeter, in order to monitor the at least one high voltage input connection 22a, 22b of the at least partially electrically operated motor vehicle 12. As the coupling devices 46a and 46b may only be accessible to the user via the user interface 40, the coupling devices 46a and 46b may only be accessible to the user when the access door 16 is opened.

In a further embodiment, the monitoring device 10 comprises the ground test port 44 that is electrically connected to the ground stud 28 located on the housing 14. A user may access the ground test port 44 via the user interface 40 in order to test whether there is continuity in the circuit between the ground stud 28 and the at least one high voltage input connection 22a and/or 22b. As the ground test port 44 is accessible to the user via the user interface 40, the ground test port 44 may only be accessible when the access door 16 is open. In an embodiment, the ground test port 44 may be able to accommodate an external monitoring and/or probing device, such as a multimeter.

In an embodiment, the user interface 40 comprises a mode switch 50. The mode switch 50 is connected to the internal controls of the monitoring device 10, such as microcontroller 52 (depicted in Fig. 6-17). In an embodiment, by engaging the mode switch 50, the testing sequence of the monitoring device 10 for detecting the presence of high voltage provided by the at least one high voltage input connection 22a, 22b may be activated. In an exemplary embodiment, the mode switch 50 may be an electrical, two position, momentary switch or a "push-button" switch. As the mode switch 50 is accessible to the user via the user interface 40, the mode switch 50 may be only accessible when the access door 16 is open.

In an embodiment, the user interface 40 comprises a door override switch 42. The door override switch 42 may be connected to the internal controls of the monitoring device 10, such as the microcontroller 52. In an embodiment, by engaging the door override switch 42, the user may override the door switch 54 when the access door 16 is open. By engaging the door override switch 42, high voltage may be present in the monitoring device 10 in order for the user to initiate monitoring of high voltage provided by the at least one high voltage input connection 22a, 22b of the at least partially electrically operated motor vehicle 12. The door override switch 42 may comprise an indicator light that may illuminate, for example red, to indicate to a user that the door switch 54 has been overridden and live high voltage may be present in the monitoring device 10. In an exemplary embodiment, the user may engage the door override switch 42, and then cycle the ignition of the at least partially electrically operated motor vehicle 12 in order to allow high voltage to enter the monitoring device 10 through the at least one high voltage input connection 22a, 22b.

In an embodiment, the user interface 40 may comprise at least one indication light in order to provide visual feedback to the user in response to an operating state of the monitoring device 10. Fig. 5 shows an embodiment of the user interface 40 which comprises indication lights 30a, 30b, 32a, 32b, 34, 36, 38a, and 38b. Each of the indicator lights 30a, 30b, 32a, 32b, 34, 36, 38a and 38b may be controlled by the microcontroller 52.

In an embodiment, the indicator light 34 may be a power light that indicates whether the monitoring device 10 is powered on through the low voltage connection 26. For example, the power light 34 may comprise three states: ON, ERROR and OFF. The power light 34 may be a multicolor LED light that can illuminate green when the monitoring device 10 is powered on through the low voltage connection 26, and can illuminate amber when the monitoring device 10 is not in a proper operational state. In an embodiment, the monitoring device 10 may be configured, through the control strategy of the microcontroller 52, to only be operational when the at least partially electrically operated motor vehicle 12 is in a particular operating state. For example, the monitoring device 10 may only be operational when the parking brake of the vehicle 12 is engaged and/or the ignition of the vehicle 12 is off. In an embodiment, the power light 34 may be illuminated amber to indicate there is an ERROR, which may mean that the monitoring device 10 is powered on through the low voltage connection 26, but the vehicle 12 is not in the particular operating state in which the monitoring device 10 is configured to be operational.

In an embodiment, the indicator light 38a may indicate to a user if live high voltage is detected in the monitoring device 10 provided by the first high voltage input connection 22a. In another embodiment, the indicator light 38b may indicate to a user if live high voltage is detected in the monitoring device 10 provided by the second high voltage input connection 22b. For example, the indicator lights 38a and 38b may comprise three states: ON, ERROR, and OFF. In an embodiment, the indicator lights 38a and 38b may be multicolor LED lights that can illuminate red in an ON state, and amber in an ERROR state. In particular, the indicator light 38a may illuminate red when live high voltage is detected provided by the first high voltage input connection 22a. Likewise, the indicator light 38b may illuminate red when live high voltage is detected provided by the second high voltage input connection 22b. The indicator light 38a may illuminate amber when high live voltage is only detected on a single side (i.e. positive or negative loop) of a secondary circuit of a circuit for detecting the presence of high voltage 80 (further shown in Figs. 10, 12, 14 and 16, and described in detail below). Likewise, the indicator light 38b may indicate amber when high live voltage is only detected on a single side (positive or negative loop) of a secondary circuit of a circuit for detecting the presence of high voltage 90 (further depicted in Figs. 11, 13, 15 and 17, and described in detail below). In an embodiment, the indicator lights 38a and 38b may not illuminate in an OFF state. In other words, the indicator lights 38a and 38b may not illuminate if there is no presence of high voltage provided by the at least one high voltage input connection 22a, 22b. In another embodiment, the indicator lights 38a and 38b may indicate in an ERROR state if it is detected that at least one transistor 76a, 76b, 76c, 76d, 84a, 84b, 84c, and/or 84d (shown in Figs. 10-17) is operating in a fault state. In an embodiment, the indicator lights 38a and 38b may be considered "voltage detection" lights. The total number of "voltage detection" lights that the monitoring device 10 comprises may be dependent on the total number of high voltage connections the monitoring device 10 accommodates.

In an embodiment, the indicator light 30a may indicate if continuity is detected within a positive loop of the secondary circuit of the circuit to detect the presence of high voltage 80 (further shown in Figs. 10, 12, 14 and 16, and described in detail below) provided by the first high voltage input connection 22a. In another embodiment, the indicator light 30b may indicate if continuity is detected within a positive loop of the secondary circuit of the circuit to detect the presence of high voltage 90 (further shown in Figs. 11, 13, 15 and 17, and described in detail below) provided by the second high voltage input connection 22b. For example, indicator lights 30a and 30b may comprise three states: ON, ERROR and OFF. In an embodiment, the indicator lights 30a and 30b may be multicolor LED lights that may illuminate blue or amber. The indicator lights 30a and 30b may illuminate blue in an ON state to indicate that continuity has been detected on each respective positive loop. In a further embodiment, the indicator lights 30a and 30b may illuminate amber in an ERROR state to indicate that at least one transistor, particularly transistors 84a and/or 84b, is operating in a fault state. The indicator lights 30a and 30b may not illuminate in an OFF state to indicate that there is not continuity detected in each respective positive loop.

In an embodiment, the indicator light 32a may indicate if continuity is detected within a negative loop of the secondary circuit of the circuit to detect the presence of high voltage 80 (further shown in Figs. 10, 12, 14 and 16, and described in detail below) provided by the first high voltage input connection 22a. In another embodiment, the indicator light 32b may indicate if continuity is detected within a negative loop of the secondary circuit of the circuit to detect the presence of high voltage 90 (further shown in Figs. 11, 13, 15 and 17, and described in detail below) provided by the second high voltage input connection 22b. For example, indicator lights 32a and 32b may comprise three states: ON, ERROR and OFF. In an embodiment, the indicator lights 32a and 32b may be multicolor LED lights that may illuminate blue or amber. The indicator lights 32a and 32b may illuminate blue in an ON state to indicate that continuity has been detected on each respective negative loop. In a further embodiment, the indicator lights 32a and 32b may illuminate amber in an ERROR state to indicate that at least one transistor, in particular transistors 84c and/or 84d, is operating in a fault state. The indicator lights 32a and 32b may not illuminate in an OFF state to indicate that continuity is not detected in each respective negative loop.

In an embodiment, the indicator light 36 may indicate if continuity is detected in the circuit between the ground stud 28 and the at least one high voltage input connection 22a, 22b. In an embodiment, the indicator light 36 may comprise an ON and OFF state. The indicator light 36 may be a single color LED light. For example, the indicator light 36 may illuminate blue. In an embodiment, the indicator light 36 may be in an ON state when the indicator light 36 illuminates blue, indicating that circuit continuity is detected between the ground stud 28 and the at least one high voltage input connection 22a, 22b. The indicator light 36 may not be illuminated in an OFF state, indicating that circuit continuity is not present between the ground stud 28 and the at least one high voltage input connection 22a and/or 22b.

Fig. 6 shows a schematic view of an electric circuit 74 of the monitoring device 10. In particular, Fig. 6 depicts a circuit 74 for providing power to the monitoring device 10 through the low voltage connection 26 in order for the microcontroller 52 to be operational. In an embodiment, the low voltage connection 26 may be connected to the microcontroller 52 through a conductive path provided by the housing 14 that, for example, is mounted to the chassis of the motor vehicle 12. In an embodiment, the circuit 74 comprises a positive power connection 58a between the low voltage connection 26 and the microcontroller 52 in order to provide low voltage to the microcontroller 52. The power connection 58a may comprise the normally closed contact 56a of the door switch 54. In an embodiment, the door switch 54 may be actuated when the access door 16 is closed (i.e. the normally closed contact 56a of the door switch 54 may be opened). Therefore, when the access door 16 is closed, low voltage is not provided to the microcontroller 52, and thus the monitoring device 10. In an embodiment, the circuit 74 further comprises a ground connection 58b between the low voltage connection 26 and the microcontroller 52.

In an embodiment, the low voltage power circuit 74 comprises a safety interlock connection 58c between the low voltage connection 26 and the microcontroller 52. The monitoring device 10 may be configured to only be operational when the at least partially electrically operated motor vehicle 12 is in a particular operating state. In an embodiment, the microcontroller 52 may receive an input signal through the safety interlock connection 58c to determine if the vehicle 12 is in the particular operating state. For example, the safety interlock connection 58c may signal whether the parking brake of the vehicle 12 is engaged. If the parking brake of the vehicle 12 is engaged, the microcontroller 52 may enable the monitoring device 10 to be operational to the user, and a signal is provided to indication light 34 to indicate an ON state. If there is not a signal received by the microcontroller 52 through the safety interlock connection 58c to indicate that the parking brake of the vehicle 12 is engaged, the microcontroller 52 may not enable the monitoring device 10 to be operational to the user, and a signal is provided to indication light 34 to indicate an ERROR state. In another example, the safety interlock connection 58c may signal whether the ignition of the vehicle 12 is engaged. If the ignition of the vehicle 12 is not engaged, the microcontroller 52 may enable the monitoring device 10 to be operational to the user, and a signal is provided to indication light 34 to indicate an ON state. If a signal is received by the microcontroller 52 through the safety interlock connection 58c to indicate that the ignition of the vehicle 12 is engaged, the microcontroller may not enable the monitoring device 10 to be operational to the user, and a signal is provided to indication light 34 to indicate an ERROR state.

Fig. 7 shows a schematic view of another electric circuit 100 of the monitoring device 10. In particular, the electric circuit 100 facilitates the connection of the indication lights 30a, 30b, 32a, 32b, 34, 36, 38a, 38b and the LED light of the door override switch 42 with the microcontroller 52. In an embodiment, a power connection 60 may be provided between the microcontroller 52 and indication lights 30a, 30b, 32a, 32b, 34, 36, 38, and the door override switch 42 in order for the microcontroller 52 to provide an output signal to the indication lights 30a, 30b, 32a, 32b, 34, 36, 38 and the door override switch 42. The output signal provided by the microcontroller 52 through the power connection 60 may control the indication state (i.e. ON, ERROR, or OFF) that each indication light 30a, 30b, 32a, 32b, 34, 36, 38 and the door override switch 42 illuminates.

Fig. 8 shows a schematic view of another electric circuit 78 of the monitoring device 10, in particular a high voltage interlock protection circuit 78. In an example, the high voltage interlock protection circuit 78 is a high voltage interlock loop (HVIL) protection circuit for the monitoring device 10 that is routed through each high voltage input connection of the monitoring device 10 and controlled by the microcontroller 52 and the door override switch 42. In an embodiment, the high voltage interlock protection circuit 78 is a low voltage circuit that comprises a connection between the low voltage connection 26 and the high voltage input connections 22a and 22b through a conductive path provided by the housing 14 that, for example, is mounted to the chassis of the motor vehicle 12. In particular, the high voltage interlock protection circuit 78 comprises two HVIL high voltage connection pins per each high voltage input connection. In an example depicted in Fig. 8 in which the monitoring device 10 accepts two high voltage input connections 22a, 22b, the high voltage interlock protection circuit 78 comprises HVIL input pin 62a and output pin 62b of high voltage input connection 22a, and HVIL input pin 62c and output pin 62d of the high voltage input connection 22b. In another embodiment, the high voltage interlock protection circuit 78 comprises a connection to the low voltage connection 26 through an HVIL input connection 58d and an HVIL output connection 58e. It should be appreciated that the high voltage interlock protection circuit 78 may be designed, with the overall monitoring device 10, to accommodate any number of high voltage input connections by routing the high voltage interlock protection circuit 78 through each high voltage input connection that the monitoring device 10 accommodates.

In an embodiment, the high voltage interlock protection circuit 78 may comprise the normally open contact 56b of the door switch 54. The door switch 54 may be spliced to the high voltage interlock protection circuit 78 at the splice points 66a and 66b. In an embodiment, the door switch 54 is considered to be actuated when the access door 16 is closed. Therefore, when the access door 16 is closed, the normally open contact 56b of the door switch 54 is closed, allowing for continuity within the high voltage interlock protection circuit 78, particularly between the low voltage HVIL input connection 58d, the HVIL input 62a, output pin 62b, input pin 62c, output 62d, and the low voltage HVIL output connection 58e. In another embodiment, when the access door 16 is opened, the normally open contact 56b of the door switch 54 is opened, breaking continuity within the high voltage interlock protection circuit 78.

In an embodiment, the high voltage battery (not shown in the figures), which may provide power to the at least one high voltage input connection 22a, 22b, of the at least partially electrically operated motor vehicle 12 comprises a battery management system (BMS) that monitors the high voltage interlock protection circuit 78. The BMS may send a pulse signal over the high voltage interlock protection circuit 78 and evaluate whether the high voltage interlock protection circuit 78 is continuous by determining if the signal returns. If the BMS determines that the high voltage interlock protection circuit 78 is not continuous (i.e. the access door 16 is open and the normally open contact 56b of the door switch 54 is open), the BMS may initiate a control sequence to shut down the high voltage system of the electrically operated motor vehicle 12 by opening the internal contactors of the high voltage battery. In an embodiment, if the high voltage system of the electrically operated motor vehicle 12 is already in an off state (e.g. the ignition of the vehicle 12 is off), the BMS, upon determination that the high voltage interlock protection circuit 78 is not continuous, will maintain the high voltage system of the at least partially electrically operated motor vehicle 12 in an off state.

In an embodiment, the user may be utilizing the monitoring device 10, depending on the use case, to test whether live high voltage from the high voltage system of the at least partially electrically operated motor vehicle 12 is present. For example, during decommissioning of the vehicle 12, a user may use the monitoring device 10 in order to ensure that no high voltage is present in the high voltage system of the vehicle 12. In an alternative example, it may be necessary for a user to measure the amount of live high voltage that is present in the high voltage system of the at least partially electrically operated motor vehicle 12. In a use case in which the user desires to test and/or measure live high voltage using the monitoring device 10 while the access door 16 is open, the user may engage the door override switch 42 in order to override the normally open contact 56b of door switch 54 in order to create a continuous high voltage interlock protection circuit 78. In particular, the high voltage interlock protection circuit 78 comprises a transistor 64 located between splice points 66a and 66b that is connected to the microcontroller 52. The transistor 64 may be in an open state by default (i.e. unless a signal is received to close the transistor 64), such that current may not flow through the transistor 64. In an embodiment, if the door override switch 42 is engaged by the user, the microcontroller 52 may send an output signal to the transistor 64 to close in order to allow current to flow. By allowing current to flow through the transistor 64, the high voltage interlock protection circuit 78 may be continuous. In an embodiment, if the user of the monitoring device 10 desires to test live high voltage, they may first engage the door override switch 42 in order to close transistor 64 and create a continuous high voltage interlock protection circuit 78. Next, the user can cycle the ignition of the at least partially electrically operated motor vehicle 12 to reengage the high voltage system. In particular, the high voltage system of the at least partially electrically operated motor vehicle 12 may be reengaged by the BMS by sending a new pulse through the high voltage interlock protection circuit 78, and once determining the high voltage interlock protection circuit 78 is continuous, the BMS will allow the high voltage battery and overall high voltage system of the vehicle 12 to remain operational.

Fig. 9 depicts an alternative embodiment of the high voltage interlock protection circuit 78. In particular, the high voltage interlock protection circuit 78 may be a KL30C circuit. In an embodiment, the high voltage interlock protection circuit 78 is a low voltage circuit that comprises a connection with the low voltage connection 26 through a conductive path provided by the housing 14 that, for example, is mounted to the chassis of the motor vehicle 12. In particular, the high voltage input protection circuit 78 comprises a connection to the low voltage connection 26 through a KL30C input 126a and a KL30C output 126b. In an embodiment, when the high voltage interlock protection circuit 78, in particular the KL30C circuit, is not continuous (i.e. current cannot flow between the KL30C input 126a and output 126b due to the normally open contact 56b of the door switch 54 being in an open state), the internal contactors of the high voltage battery of the at least partially electrically operated motor vehicle 12 may lose control power, and the high voltage battery may be forced and/or maintained in an off state. In an embodiment, the high voltage interlock protection circuit 78 may be a KL30C circuit when the at least one high voltage input connection 22a and/or 22b comprises cable and gland inputs (as depicted in the exemplary embodiment of Fig. 4). In this case, the high voltage interlock protection circuit 78 may not be looped through the high voltage input connections 22a and 22b.

Figs. 10-17 each show a schematic view of an electric circuit 80 and 90, respectively, of the monitoring device 10. In particular, the electric circuits 80 and 90 each provide a primary circuit for monitoring the presence of high voltage provided by the at least one high voltage input connection 22a, 22b of the monitoring device 10. Further, the electric circuits 80 and 90 each provide a secondary circuit for monitoring for faults within the electric circuits 80 and 90 to ensure that each circuit 80 and 90 is complete and operating accurately. For example, if at least one of the primary circuits determines that no high voltage provided by the at least one high voltage input connection 22a, 22b of the monitoring device 10 is present, the at least one respective secondary circuit may be activated by the microcontroller 52 to ensure that there is not a fault in the electric circuit 80 and/or 90 that may cause the primary circuit to perform a false reading. It should be appreciated that an electric circuit as represented by electric circuits 80 and 90 may be replicated such that each high voltage input connection that the monitoring device 10 accommodates comprises its own electric circuit that comprises a primary and secondary monitoring circuit.

In an embodiment, before a user connects an external monitoring or probing device, such as a multimeter, through coupling devices 46a, 46b, and/or test port 44 in order to monitor the at least one high voltage input connection 22a, 22b, the user may use the monitoring device 10 to perform a testing sequence to determine if high voltage is present in the monitoring device 10 provided by the at least one high voltage input connection 22a, 22b. By performing the testing sequence, the user may assess whether it is safe to monitor the at least one high voltage input connection 22a, 22b. In an embodiment, the testing sequence may be controlled by the microcontroller 52, and may use each primary circuit and secondary circuit provided by the electric circuits 80 and 90 in order to provide feedback to the user through the user interface 40.

In an embodiment, the user may initiate the testing sequence through the mode switch 50. The mode switch 50 may be connected to the microcontroller 52. In an embodiment, by engaging the mode switch 50, the user may initiate the testing sequence of the monitoring device 10 for monitoring the at least one high voltage input connection 22a, 22b. The mode switch 50 may be an electrical, two position, momentary switch or a "push-button" switch. For example, the user may engage the mode switch 50 by pressing and holding the mode switch 50 for three seconds or longer. Upon release of the mode switch 50, the microcontroller 52 may initiate the testing sequence.

In an embodiment, the electric circuit 80 comprises a connection between the first high voltage input connection 22a and the microcontroller 52. In the embodiment shown in Fig. 10, the first high voltage input connection 22a comprises the positive input pins 68a and 68b, and the negative input pins 70a and 70b. Each input pin 68a, 68b, 70a, 70b is coupled with a circuit protector 72 in order to limit the amount of current provided through the electric circuit 80. For example, the circuit protectors 72 may provide a limit of one ampere of current to the electric circuit 80.

In an embodiment, the electric circuit 90 comprises a connection between the second high voltage input connection 22b and the microcontroller 52. In the embodiment shown in Fig. 11, the second high voltage input connection 22b comprises the positive input pins 68c and 68d and the negative input pins 70c and 70d. Each input pin 68c, 68d, 70c, 70d is coupled with a circuit protector 72 in order to limit the amount of current provided through the electric circuit 90. For example, the circuit protectors 72 may provide a limit of one ampere of current to the electric circuit 90.

In an alternative embodiment shown in Fig 12, the first high voltage input connection 22a comprises a positive input 106a connected to a first positive bus bar 108a, and a negative input 104a connected to a first negative bus bar 110a. In an embodiment, the first positive bus bar 108a and the first negative bus bar 110a are arranged within the housing 14 of the monitoring device 10. The electric circuit 80 may be connected to the positive bus bar 108a in order to measure the presence of high voltage provided by the first high voltage input connection 22a at connection points 118a and 118b. The electric circuit 80 may be further connected to the negative bus bar 110a in order to measure the presence of high voltage provided by the first high voltage input connection 22a at the connection points 120a and 120b. Each connection point 118a, 118b, 120a, 120b is coupled with a circuit protector 72 in order to limit the amount of current provided through the electric circuit 80. For example, the circuit protectors 72 may provide a limit of one ampere of current to the electric circuit 80. In a further embodiment of Fig. 12, the positive bus bar 108a may be coupled with the first positive high voltage output 24a. The negative bus bar 110a may be coupled with the first negative high voltage output 24b.

In the alternative embodiment shown in Fig. 13, the second high voltage input connection 22b comprises a positive input 106b connected to a second positive bus bar 108b, and a negative input 104b connected to a second negative bus bar 110b. In an embodiment, the second positive bus bar 108b and the second negative bus bar 110b are arranged within the housing 14 of the monitoring device 10. The electric circuit 90 may be connected to the positive bus bar 108b in order to measure the presence of high voltage provided by the second high voltage input connection 22b at connection points 118c and 118d. The electric circuit 90 may be further connected to the negative bus bar 110a in order to measure the presence of high voltage provided by the second high voltage input connection 22b at the connection points 120c and 120d. Each connection point 118c, 118d, 120c, 120d is coupled with a circuit protector 72 in order to limit the amount of current provided through the electric circuit 90. For example, the circuit protectors 72 may provide a limit of one ampere of current to the electric circuit 90. In a further embodiment of Fig. 13, the positive bus bar 108b may be coupled with the second positive high voltage output 24c. The negative bus bar 110b may be coupled with the second negative high voltage output 24d.

In an alternative embodiment shown in Fig. 14, the first high voltage input connection 22a may be connected to a remote and/or centralized PDU 112 of the at least partially electrically operated motor vehicle 12. The first high voltage input connection 22a is connected to a first high voltage connection 116a. In an embodiment, the first high voltage input connection 22a and the first high voltage connection 116a may be coupled through a first high voltage cable 114a. In an embodiment, the PDU 112 may comprise the first positive bus bar 108a and the first negative bus bar 110a. The first high voltage connection 116a may be connected with the positive bus bar 108a at two points, particularly the connection points 118a and 118b in order for the electric circuit 80 to measure the presence of high voltage provided by the first high voltage input connection 22a. Further, the first high voltage connection 116a may be connected to the negative bus bar 110a at two points, particularly the connection points 120a and 120b in order for the electric circuit 80 to measure the presence of high voltage provided by the first high voltage input connection 22a. Each connection point 118a, 118b, 120a, and 120b is coupled with a circuit protector 72 in order to limit the amount of current provided through the electric circuit 80. For example, the circuit protectors 72 may provide a limit of one ampere of current to the electric circuit 80.

In the alternative embodiment shown in Fig. 15, the second high voltage input connection 22b may be connected to a remote and/or centralized PDU 112 of the at least partially electrically operated motor vehicle 12. The second high voltage input connection 22b is connected to a second high voltage connection 116b. In an embodiment, the second high voltage input connection 22b and second high voltage connection 116b may be coupled through a second high voltage cable 116b. In an embodiment, the PDU 112 may comprise the second positive bus bar 108b and the second negative bus bar 110b. The second high voltage connection 117b may be connected with the second positive bus bar 108b at two points, particularly the connection points 118c and 118d in order for the electric circuit 90 to detect the presence of high voltage provided by the second high voltage input connection 22b. Further, the second high voltage connection 116b may be connected to the second negative bus bar 110b at two points, particularly the connection points 120c and 120d in order for the electric circuit 90 to detect the presence of high voltage provided by the second high voltage input connection 22b. Each connection point 118c, 118d, 120c, and 120d is coupled with a circuit protector 72 in order to limit the amount of current provided through the electric circuit 90. For example, the circuit protectors 72 may provide a limit of one ampere of current to the electric circuit 90.

In a further embodiment, the electric circuit 80 comprises the test ports 48a, 48b of the coupling device 46a. In an embodiment, each test port 48a, 48b may comprise a circuit protector 74 in order to limit the amount of current provided to the test port 48a, 48b that is accessible to the user when probing or testing with an external monitoring device. For example, the circuit protector 74 may provide a limit of a tenth of an ampere of current to the test ports 48a and 48b.

In a further embodiment, the electric circuit 90 comprises the test ports 48c, 48d of the coupling device 46b. In an embodiment, each test port 48c, 48d may comprise a circuit protector 74 in order to limit the amount of current provided to the test ports 48c, 48d that is accessible to the user when probing or testing with an external monitoring device. For example, the circuit protector 74 may provide a limit of a tenth of an ampere of current to the test ports 48c and 48d.

In an embodiment, the electric circuit 80 and 90 comprises transistors 76a, 76b, 76c, 76d, 84a, 84b, 84c, 84d that may be smart transistors, such as metal-oxide-semiconductor field-effect transistors (MOSFETs). Through the use of transistors 76a, 76b, 76c, 76d, 84a, 84b, 84c, 84d, the microcontroller 52 may manage the amount of power available through the monitoring device 10, and to the user, in a controlled and selectable way. In particular, the microcontroller 52 may control the operating state of each transistor 76a, 76b, 76c, 76d, 84a, 84b, 84c, 84d by opening or closing each transistor 76a, 76b, 76c, 76d, 84a, 84b, 84c, 84d to enable or disable current to flow on each primary or secondary circuit of the electric circuits 80 and 90. In an embodiment, the microcontroller 52 may detect if a transistor 76a, 76b, 76c, 76d, 84a, 84b, 84c, 84d is operating in a fault state, and may notify the user through the user interface 40 by indicating, through each respective indicator light 30a, 32a, 30b, 32b, an ERROR state.

In an embodiment, the microcontroller 52 may control both the primary and secondary circuits of electric circuits 80 and 90. The microcontroller 52 comprises a first primary circuit control 86a that may control the operating state of transistors 76a and 76b, and a second primary circuit control 86b that may control the operating state of transistors 76c and 76d. In a further embodiment, the microcontroller 52 comprises a first positive secondary circuit control 94a that controls the operating state of transistor 84a, and a second positive secondary circuit control 94b that controls the operating state of transistor 84b. The microcontroller 52 further comprises a first negative secondary circuit control 94c that controls the operating state of transistor 84c, and a second negative secondary circuit control 94d that controls the operating state of transistor 84d.

In another embodiment, once the user initiates the testing sequence by engaging the mode switch 50, a first phase of the testing sequence is to activate the primary circuit for monitoring of the presence of high voltage. In an embodiment, the primary circuit may comprise two portions, each portion creating a loop between the at least one high voltage input connection 22a, 22b and the microcontroller 52. In particular, the microcontroller 52, through primary circuit control 86a, may close the transistors 76a and 76b on the first loop, and through primary circuit control 86b may close the transistors 76c and 76d on the second loop. By closing the transistors 76a, 76b, 76c, 76d, current is allowed to flow through the primary circuit and the at least one high voltage input 22a, 22b and the microcontroller 52.

In an embodiment, each loop of the primary circuit may comprise an optocoupler, in particular optocoupler 98a on the first loop and optopcoupler 98b on the second loop. By closing the transistors 76a, 76b, 76c, 76d, the microcontroller 52 allows high voltage power to flow from the at least one high voltage input connection 22a, 22b through the optocouplers 98a and 98b. In another embodiment, each loop of the primary circuit may comprise a resistor 82 in order to allow an appropriate amount of current to flow to each optocoupler 98a, 98b. Upon allowing and present high voltage to flow through optocoupler 98a and 98b, the optocouplers 98a and 98b may provide a signal, particularly using light, to microcontroller 52 depending on whether high voltage is flowing through the optocoupler 98a, 98b. For example, if the user initiates the testing sequence, and the transistors 76a, 76b, 76c, and 76d are closed, but no current flows through either optocoupler 98a, 98b due to high voltage not being present in the monitoring device 10 by the at least one high voltage input connection 22a, 22b, then the optocouplers 78 and 78b may not provide a signal to the microcontroller 52. In another example, if the user initiates the testing sequence, and the transistors 76a, 76b, 76c, and 76d are closed, and current flows through both optocouplers 98a, 98b due to high voltage being present in the monitoring device 10 by the at least one high voltage input connection 22a, 22b, then the optocouplers 98a and 98b may provide a signal to the microcontroller 52.

In an embodiment, the microcontroller 52 may comprise a first primary loop input 88a and a first primary loop output 88b. The first primary loop input 88a and output 88b may be connected with the optocoupler 98a in order for the microcontroller 52 to receive a signal of voltage detection from the optocoupler 98a. In another embodiment, the microcontroller 52 may comprise a second primary loop input 92a and a second primary loop output 92b. The second primary loop input 92a and output 92b may be connected with the optocoupler 98b in order for the microcontroller 52 to receive a signal of voltage detection from the optocoupler 98b.

In a further embodiment, in response to the microcontroller 52 receiving a signal from the optocoupler 98a and/or 98b, the microcontroller 52 may provide an output signal through the power line 60 of the electric circuit 100 in order to modify the indication state of at least one indication light on the user interface 40. In particular, the microcontroller 52 may provide an output signal to the indicator lights 38a, 38b, 36, 30a, 30b, 32a, and/or 32b. For example, if the microcontroller 52 receives a signal from the optocouplers 98a and 98b that high voltage provided by the at least one high voltage input connection 22a, 22b is flowing through the optocouplers 98a and 98b, then the microcontroller 52 may send an output signal to illuminate the indicator lights 38a, 38b, 36, 30a, 30b, 32a, and/or 32b to indicate an ON state. In another example, if the microcontroller 52 receives a signal from only one of the optocouplers 98a or 98b that high voltage is provided by the at least one high voltage input connection 22a, 22b, then the microcontroller 52 may send an output signal to illuminate the indicator lights 38a, 38b, 36, 30a, 30b, 32a, and/or 32b to indicate an ERROR state. In an embodiment, the indicator lights 38a, 30a and 32b may indicate whether voltage is detected within the electric circuit 80 provided by the first high voltage input connection 22a. The indicator lights 38b, 30b and 32b may indicate whether voltage is detected within the electric circuit 90 provided by the second high voltage input connection 22b. In an embodiment, if the optocouplers 98a and 98b both do not return a signal after the microcontroller 52 closes transistors 76a, 76b, 76c and 76d, then the indicator lights 38a, 38b, 36, 30a, 30b, 32a, 32b will remain unilluminated in an OFF state.

In an embodiment, if after completion of the first phase of the testing sequence the optocouplers 98a and 98b do not provide a signal to the microcontroller 52 (i.e. no voltage is detected to be present on either the first loop and/or second loop of the primary circuit), then the microcontroller 52 may activate the secondary circuit to monitor for the completeness of the electric circuit 80 and/or 90. The secondary circuit may comprise two portions, in particular a positive portion and a negative portion, each creating a loop between the at least one high voltage input connection 22a, 22b and the microcontroller 52. In an embodiment shown in Figs. 10 and 11, a positive loop of the secondary circuit may connect the positive input pins 68a and 68b of the first high voltage input connection 22a, and the positive input pins 68c and 68d of the second high voltage input connection 22b and the microcontroller 52. A negative loop of the secondary circuit may connect the negative input pins 70a and 70b of the first high voltage input connection 22b, and the negative input pins 70c and 70d of the second high voltage input connection 22b and the microcontroller 52. In an embodiment, the secondary circuit may test whether there is continuity that can be detected between the positive input pins 68a and 68b, and/or 68c and 68d, and between the negative input pins 70a and 70b, and/or 70c and 70d.

In an embodiment shown in Figs. 12-17, a positive loop of the secondary circuit may connect the connection points 118a and 118b of the first high voltage input connection 22a, and the connection points 118c and 118d of the second high voltage input connection 22b and the microcontroller 52. A negative loop of the secondary circuit may connect the connection points 120a and 120b of the first high voltage input connection 22a, and the connection points 120c and 120d of the second high voltage input connection 22b and the microcontroller 52. In an embodiment, the secondary circuit may test whether there is continuity that can be detected between the connection points 118a and 118b, and/or 118c and 118d, and between the connection points 120a and 120b and/or 120c and 120d.

In an embodiment, upon initiating the second phase of the testing sequence, the microcontroller 52 may open the transistors 76a, 76b, 76c, and 76d through the primary circuit controls 86a and 86b. By opening the transistors 76a, 76b, 76c, and 76d, current is unable to flow to the optocouplers 98a and 98b. Further the microcontroller 52 may close the transistors 84a, 84b, 84c, and 84d through the secondary circuit controls 94a, 94b, 94c and 94d, respectively. In the particular embodiment shown in Figs. 10 and 11, by closing transistors 84a and 84b, current may flow on the positive loop of the secondary circuit such that continuity may be monitored between the positive input pins 68a and 68b, and/or 68c and 68d by the microcontroller 52. Alternatively in the particular embodiments shown in Figs. 12-17, by closing transistors 84a and 84b, current may flow on the positive loop of the secondary circuit such that continuity may be monitored between the connection points 118a and 118b, and/or 118c and 118d by the microcontroller 52.

In the embodiment shown in Figs. 10 and 11, by closing transistors 84c and 84d, current may flow on the negative loop of the secondary circuit such that continuity may be monitored between the negative input pins 70a and 70b, and/or 70c and 70d. Alternatively in the embodiments shown in Figs. 12-17, by closing the transistors 84c and 84d, current may flow on the negative loop of the secondary circuit such that continuity may be monitored between the connection points 120a and 120b, and/or 120c and 120d.

In an embodiment, the microcontroller 52 may comprise a positive loop input 96a and output 96b that form the positive secondary loop with positive input pins 68a and 68b, and/or 68c and 68d, or with the connection points 118a and 118b, and/or 118c and 118d. The microcontroller 52 may further comprise a negative secondary loop input 102a and output 102b that form the negative loop with negative input pins 70a and 70b, and/or 70c and 70d, or with connection points 120a and 120b, and/or 120c and 120d.

In an embodiment, in response to the microcontroller 52 detecting whether there is continuity within the positive and/or negative loop of the secondary circuit, the microcontroller 52 may provide an output signal through the power line 60 of the electric circuit 100 in order to modify the indication state of at least one indication light on the user interface 40. In particular, the microcontroller 52 may provide an output signal to the indicator lights 30a, 30b, 32a, 32b and/or 36. For example, if the microcontroller 52 detects that there is continuity on the positive loop between the positive input pins 68a and 68b, and/or 68c and 68d, then the microcontroller 52 may send an output signal to illuminate the indicator lights 30a and/or 30b to indicate an ON state. Alternatively, if the microcontroller 52 detects that there is continuity on the positive loop between the connection points 118a and 118b, and/or 118c and 118d, then the microcontroller 52 may send an output signal to illuminate the indicator lights 30a and/or 30b to indicate an ON state. In another example, if the microcontroller 52 determines that transistor 84a and/or 84b is operating in a fault state, then the microcontroller 52 may send an output signal to illuminate the indicator lights 30a and/or 30b to indicate an ERROR state. In another example, if the microcontroller 52 detects that there is continuity on the negative loop between the negative input pins 70a and 70b, and/or 70c and 70d, then the microcontroller 52 may send an output signal to illuminate the indicator lights 32a and/or 32b to indicate an ON state. Alternatively, if the microcontroller 52 detects that there is continuity on the negative loop between the connection points 120a and 120b, and/or 120c and 120d, then the microcontroller 52 may send an output signal to illuminate the indicator lights 32a and/or 32b to indicate an ON state. In another example, if the microcontroller 52 determines that transistor 84c and/or 84d is operating in a fault state, then the microcontroller 52 may send an output signal to illuminate the indicator lights 32a and/or 32b to indicate an ERROR state. In an embodiment, if the microcontroller 52 does not detect continuity on either the first or the second loop of the secondary circuit, then the indicator lights 30a, 30b, 32a, 32b and 36 will remain unilluminated in an OFF state.

In an embodiment, Figs. 12 and 13 show the ground stud 28 and the ground test port 44 that is electrically connected to the ground stud 28. The ground stud 28 may be electrically connected with the at least one high voltage input connection 22a, 22b. A user may access the ground test port 44 via the user interface 40 in order to measure for voltage in the circuit between the ground stud 28 and the at least one high voltage connection 22a and/or 22b. In an embodiment, the ground test port 44 may be able to accommodate an external monitoring and/or probing device, such as a multimeter. In an embodiment, upon detecting continuity on the first and second loop of the secondary circuit, the indicator light 36 may be illuminated to an ON state.

Fig. 16 shows an alternative embodiment of the electric circuit 80 in which the first high voltage input connection 22a comprises the positive cable and gland input 122a and the negative cable and gland input 124a. In an embodiment, the positive cable and gland input 122a may be connected to the positive bus bar 108a, and the negative cable and gland input 124a may be connected to the negative bus bar 110a. Fig. 17 shows an alternative embodiment of the electric circuit 90 in which the second high voltage input connection 22b comprises the positive cable and gland input 122b and the negative cable and gland input 124b. In an embodiment, the positive cable and gland input 122b may be connected to the positive bus bar 108b, and the negative cable and gland input 124b may be connected to the negative bus bar 110b.

## Claims

1. A monitoring device (10) for an at least partially electrically operated motor vehicle (12), the monitoring device (10) comprising:
a housing (14) configured to be arranged on the motor vehicle (12) and to accept at least one high voltage input connection (22a, 22b),
an access door (16) configured to provide access to a user interface (40),
at least one electric circuit for monitoring the presence of high voltage (80, 90) provided by the at least one high voltage input connection (22a, 22b),
at least one high voltage interlock protection circuit (78), and
a microcontroller (52);
wherein the microcontroller (52) controls the at least one electric circuit for monitoring the presence of high voltage (80, 90) and the at least one high voltage interlock protection circuit (78), and
wherein the microcontroller (52) controls indication provided through the user interface (40) based on the presence of high voltage within the at least one electric circuit for monitoring the presence of high voltage (80, 90),
**characterised in that** the at least one electric circuit for monitoring the presence of high voltage (80, 90) and the at least one high voltage interlock protection circuit (78) are provided within the housing (14), and **in that** the access door (16) comprises a door switch (54) configured to break continuity in the at least one high voltage interlock protection circuit (78) upon opening of the access door (16).

2. The monitoring device (10) according to claim 1,
**characterized in that**
the at least one electric circuit for monitoring the presence of high voltage (80, 90) comprises a primary circuit (88a, 88b) (92a, 92b) controlled by the microcontroller (52) for monitoring the presence of high voltage, and a secondary circuit (96a, 96b) (102a, 102b) controlled by the microcontroller (52) for monitoring for faults within the at least one electric circuit for monitoring the presence of high voltage (80, 90).

3. The monitoring device (10) according to any one of claims 1 or 2,
**characterized in that**
the user interface (40) comprises at least one indication light (30a, 30b, 32a, 32b, 36, 38a, 38b) controlled by the microcontroller (52).

4. The monitoring device (10) according to any one of claims 1 to 3,
**characterized in that**
the user interface (40) comprises at least one coupling device (46a, 46b), wherein the at least one coupling device (46a, 46b) is configured to connect to an external monitoring device.

5. The monitoring device (10) according to any one of claims 1 to 4,
**characterized in that**
the user interface (40) comprises a mode switch (50) that is configured to initiate a testing sequence controlled by the microcontroller (52).

6. The monitoring device (10) according to any one of claims 2 to 5,
**characterized in that**
the microcontroller (52) is configured to activate the secondary circuit (96a, 96b) (102a, 102b) of the at least one electric circuit for monitoring the presence of high voltage (80, 90) when the primary circuit (88a, 88b) (92a, 92b) of the at least one electric circuit for monitoring the presence of high voltage (80, 90) does not detect the presence of high voltage.

7. The monitoring device (10) according to any of claims 1 to 6,
**characterized in that**
the microcontroller (52) is configured to receive a safety interlock signal (58c) that indicates the operating state of the vehicle (12), wherein the microcontroller (52) controls the operating state of the monitoring device (10) based on the safety interlock signal (58c).

8. The monitoring device (10) according to any one of claims 1 to 7,
**characterized in that**
the microcontroller (52) is configured to control the at least one electric circuit for monitoring the presence of high voltage (80, 90) and the at least one high voltage interlock protection circuit (78) through at least one transistor (64, 76a, 76b, 76c, 76d, 84a, 84b, 84c, 84d).

9. The monitoring device (10) according to any one of claims 1 to 8,
**characterized in that**,
the user interface (40) may comprise a door override switch (42) configured to restore continuity in the at least one high voltage interlock protection circuit (78) after the access door (16) is opened, wherein the microcontroller (52) is configured to close a transistor (64) upon engagement of the door override switch (42).

## Patentansprüche

1. Überwachungsvorrichtung (10) für ein zumindest teilweise elektrisch betriebenes Kraftfahrzeug (12), wobei die Überwachungsvorrichtung (10) umfasst:
ein Gehäuse (14), das ausgebildet ist an dem Kraftfahrzeug (12) angeordnet zu werden und mindestens einen Hochspannungs-Eingangsanschluss (22a, 22b) aufzunehmen,
eine Zugangstür (16), die ausgebildet ist Zugang zu einer Benutzerschnittstelle (40) zu bieten,
mindestens eine elektrische Schaltung zum Überwachen des Vorhandenseins von Hochspannung (80, 90), die von dem mindestens einen Hochspannungs-Eingangsanschluss (22a, 22b) bereitgestellt wird,
mindestens eine Hochspannungs-Verriegelungsschutzschaltung (78) und einen Mikrocontroller (52);
wobei der Mikrocontroller (52) die mindestens eine elektrische Schaltung zum Überwachen des Vorhandenseins von Hochspannung (80, 90) und die mindestens eine Hochspannungs-Verriegelungsschutzschaltung (78) steuert, und
wobei der Mikrocontroller (52) eine über die Benutzerschnittstelle (40) bereitgestellte Anzeige auf der Grundlage des Vorhandenseins einer Hochspannung innerhalb der mindestens einen elektrischen Schaltung zur Überwachung des Vorhandenseins einer Hochspannung (80, 90) steuert,
**dadurch gekennzeichnet, dass**
die mindestens eine elektrische Schaltung zum Überwachen des Vorhandenseins von Hochspannung (80, 90) und die mindestens eine Hochspannungs-Verriegelungsschutzschaltung (78) innerhalb des Gehäuses (14) vorgesehen sind,
und dass die Zugangstür (16) einen Türschalter (54) umfasst, der ausgebildet ist, beim Öffnen der Zugangstür (16), eine Kontinuität in der mindestens einen Hochspannungs-Verriegelungsschutzschaltung (78) zu unterbrechen.

2. Die Überwachungsvorrichtung (10) gemäß Anspruch 1, **dadurch gekennzeichnet, dass** die mindestens eine elektrische Schaltung zum Überwachen des Vorhandenseins von Hochspannung (80, 90) eine Primärschaltung (88a, 88b) (92a, 92b), die von dem Mikrocontroller (52) zur Überwachung des Vorhandenseins von Hochspannung gesteuert wird, und eine Sekundärschaltung (96a, 96b) (102a, 102b) umfasst, die von dem Mikrocontroller (52) zur Überwachung von Fehlern innerhalb der mindestens einen elektrischen Schaltung zur Überwachung des Vorhandenseins von Hochspannung (80, 90) gesteuert wird.

3. Die Überwachungsvorrichtung (10) gemäß einem der Ansprüche 1 oder 2, **dadurch gekennzeichnet, dass**
die Benutzerschnittstelle (40) mindestens eine Anzeigeleuchte (30a, 30b, 32a, 32b, 36, 38a, 38b) umfasst, die von dem Mikrocontroller (52) gesteuert wird.

4. Die Überwachungsvorrichtung (10) gemäß einem der Ansprüche 1 bis 3, **dadurch gekennzeichnet, dass**
die Benutzerschnittstelle (40) mindestens eine Kopplungsvorrichtung (46a, 46b) umfasst, wobei die mindestens eine Kopplungsvorrichtung (46a, 46b) ausgebildet ist mit einer externen Überwachungsvorrichtung verbunden zu werden.

5. Die Überwachungsvorrichtung (10) gemäß einem der Ansprüche 1 bis 4, **dadurch gekennzeichnet, dass**
die Benutzerschnittstelle (40) einen Betriebsartenschalter (50) umfasst, der ausgebildet ist eine vom Mikrocontroller (52) gesteuerte Testsequenz zu initiieren.

6. Die Überwachungsvorrichtung (10) gemäß einem der Ansprüche 2 bis 5, **dadurch gekennzeichnet, dass**
der Mikrocontroller (52) ausgebildet ist die Sekundärschalung (96a, 96b) (102a, 102b) der mindestens einen elektrischen Schaltung zur Überwachung des Vorhandenseins einer Hochspannung (80, 90) zu aktivieren, wenn die Primärschaltung (88a, 88b) (92a, 92b) der mindestens einen elektrischen Schaltung zur Überwachung des Vorhandenseins einer Hochspannung (80, 90) das Vorhandensein einer Hochspannung nicht erkennt.

7. Die Überwachungsvorrichtung (10) gemäß einem der Ansprüche 1 bis 6, **dadurch gekennzeichnet, dass**
der Mikrocontroller (52) ausgebildet ist ein Sicherheitsverriegelungssignal (58c) zu empfangen, das den Betriebszustand des Fahrzeugs (12) anzeigt, wobei der Mikrocontroller (52) den Betriebszustand der Überwachungsvorrichtung (10) auf der Grundlage des Sicherheitsverriegelungssignals (58c) steuert.

8. Die Überwachungsvorrichtung (10) gemäß einem der Ansprüche 1 bis 7, **dadurch gekennzeichnet, dass**
der Mikrocontroller (52) ausgebildet ist die mindestens eine elektrische Schaltung zum Überwachen des Vorhandenseins von Hochspannung (80, 90) und die mindestens einen Hochspannungs-Verriegelungsschutzschaltung (78) über mindestens einen Transistor (64, 76a, 76b, 76c, 76d, 84a, 84b, 84c, 84d) zu steuern.

9. Die Überwachungsvorrichtung (10) gemäß einem der Ansprüche 1 bis 8, **dadurch gekennzeichnet, dass**
die Benutzerschnittstelle (40) einen Türüberbrückungsschalter (42) umfasst, der ausgebildet ist eine Kontinuität in der mindestens einen Hochspannungs-Verriegelungsschutzschaltung (78) wiederherzustellen, nachdem die Zugangstür (16) geöffnet wurde, wobei der Mikrocontroller (52) ausgebildet ist einen Transistor (64) zu schließen, wenn der Türüberbrückungsschalter (42) betätigt wird.

## Revendications

1. Dispositif de surveillance (10) pour un véhicule à moteur (12) fonctionnant au moins partiellement à l'électricité, le dispositif de surveillance (10) comprenant :
un boîtier (14) configuré pour être disposé sur le véhicule à moteur (12) et pour accepter au moins une connexion d'entrée haute tension (22a, 22b),
une porte d'accès (16) configurée pour donner accès à une interface utilisateur (40), au moins un circuit électrique pour surveiller la présence d'une haute tension (80, 90) fournie par la au moins une connexion d'entrée haute tension (22a, 22b),
au moins un circuit de protection à verrouillage haute tension (78), et un microcontrôleur (52) ;
dans lequel le microcontrôleur (52) commande le au moins un circuit électrique pour surveiller la présence de haute tension (80, 90) et le au moins un circuit de protection à verrouillage haute tension (78), et
dans lequel le microcontrôleur (52) contrôle l'indication fournie par l'interface utilisateur (40) en fonction de la présence d'une haute tension dans le au moins un circuit électrique pour surveiller la présence d'une haute tension (80, 90),
**caractérisé en ce que**
le au moins un circuit électrique pour surveiller la présence d'une haute tension (80, 90) et le au moins un circuit de protection à verrouillage haute tension (78) sont prévus à l'intérieur du boîtier (14),
et **en ce que** la porte d'accès (16) comprend un interrupteur de porte (54) configuré pour interrompre la continuité dans au moins un circuit de protection à verrouillage haute tension (78) lors de l'ouverture de la porte d'accès (16).

2. Le dispositif de surveillance (10) selon la revendication 1, **caractérisé en ce que** le au moins un circuit électrique pour surveiller la présence d'une haute tension (80, 90) comprend un circuit primaire (88a, 88b) (92a, 92b) commandé par le microcontrôleur (52) pour surveiller la présence de haute tension, et un circuit secondaire (96a, 96b) (102a, 102b) commandé par le microcontrôleur (52) pour surveiller les défauts dans le au moins un circuit électrique pour surveiller la présence de haute tension (80, 90).

3. Le dispositif de surveillance (10) selon l'une quelconque des revendications 1 ou 2, **caractérisé en ce que**
l'interface utilisateur (40) comprend au moins un voyant lumineux (30a, 30b, 32a, 32b, 36, 38a, 38b) commandé par le microcontrôleur (52).

4. Le dispositif de surveillance (10) selon l'une quelconque des revendications 1 à 3, **caractérisé en ce que**
l'interface utilisateur (40) comprend au moins un dispositif de couplage (46a, 46b), dans lequel le au moins un dispositif de couplage (46a, 46b) est configuré pour se connecter à un dispositif de surveillance externe.

5. Le dispositif de surveillance (10) selon l'une quelconque des revendications 1 à 4, **caractérisé en ce que**
l'interface utilisateur (40) comprend un commutateur de mode (50) qui est configuré pour lancer une séquence de test contrôlée par le microcontrôleur (52).

6. Le dispositif de surveillance (10) selon l'une quelconque des revendications 2 à 5, **caractérisé en ce que**
le microcontrôleur (52) est configuré pour activer le circuit secondaire (96a, 96b) (102a, 102b) du au moins un circuit électrique pour surveiller la présence d'une haute tension (80, 90) lorsque le circuit primaire (88a, 88b) (92a, 92b) du au moins un circuit électrique pour surveiller la présence d'une haute tension (80, 90) ne détecte pas la présence d'une haute tension.

7. Dispositif de surveillance (10) selon l'une quelconque des revendications 1 à 6, **caractérisé en ce que**
le microcontrôleur (52) est configuré pour recevoir un signal de verrouillage de sécurité (58c) qui indique l'état de fonctionnement du véhicule (12), dans lequel le microcontrôleur (52) contrôle l'état de fonctionnement du dispositif de surveillance (10) sur la base du signal de verrouillage de sécurité (58c).

8. Dispositif de surveillance (10) selon l'une quelconque des revendications 1 à 7, **caractérisé en ce que**
le microcontrôleur (52) est configuré pour contrôler au moins un circuit électrique pour surveiller la présence d'une haute tension (80, 90) et au moins un circuit de protection de verrouillage haute tension (78) par l'intermédiaire d'au moins un transistor (64, 76a, 76b, 76c, 76d, 84a, 84b, 84c, 84d).

9. Le dispositif de surveillance (10) selon l'une quelconque des revendications 1 à 8, **caractérisé en ce que**
l'interface utilisateur (40) peut comprendre un interrupteur de déverrouillage de porte (42) configuré pour rétablir la continuité dans le au moins un circuit de protection à verrouillage haute tension (78) après l'ouverture de la porte d'accès (16), dans lequel le microcontrôleur (52) est configuré pour fermer un transistor (64) lors de l'enclenchement de l'interrupteur de déverrouillage de porte (42).
